Europäisches Patentamt

European Patent Office

Office européen des brevets

(19)

(11) **EP 1 512 984 A1**

(12) **EUROPEAN PATENT APPLICATION**

(43) Date of publication:
**09.03.2005 Bulletin 2005/10**

(51) Int Cl.⁷: $G01R\ 33/46$

(21) Application number: **03019587.9**

(22) Date of filing: **03.09.2003**

(84) Designated Contracting States:
**AT BE BG CH CY CZ DE DK EE ES FI FR GB GR HU IE IT LI LU MC NL PT RO SE SI SK TR**
Designated Extension States:
**AL LT LV MK**

(71) Applicants:
• **Kessler, Horst, Prof. Dr.**
  **85747 Garching (DE)**
• **Luy, Burkhard, Dr.**
  **85354 Freising (DE)**
• **Kobzer, Kyril**
  **85748 Garching (DE)**

(72) Inventors:
• **Kessler, Horst, Prof. Dr.**
  **85747 Garching (DE)**
• **Luy, Burkhard, Dr.**
  **85354 Freising (DE)**
• **Kobzer, Kyril**
  **85748 Garching (DE)**

(74) Representative: **HOFFMANN - EITLE**
**Patent- und Rechtsanwälte**
**Arabellastrasse 4**
**81925 München (DE)**

(54) **A polymer stick and a reliable method for measuring residual dipolar couplings in routine NMR spectroscopy in non-aqueous solvents**

(57) The present invention relates to a cylindrical stick for NMR measurements, consisting of a cross-linked polymer, wherein the stick has a circular or elliptical cross-section, a diameter of 0.1 to 8 mm and a length of 5 to 50 mm, and wherein the polymer used for the stick is derived from an uncross-linked polymer which is less soluble in water than polyacrylamide. The invention also pertains to a process of measuring NMR experiments, using the stick of the invention, and to a ready-to-use NMR tube containing the stick. The stick of the invention can be used for measuring residual dipolar couplings in NMR experiments.

## Description

### Technical Field of the Invention

The present invention pertains to the field of NMR spectroscopy. Specifically, the present invention provides a new additive that can be used for determining residual dipolar couplings.

### Background of the Invention

High resolution NMR measurements of small organic molecules are usually carried out in solution. These molecules can rotate freely and their orientation relative to the magnetic field and their surrounding is variable. For these reasons, NMR spectra measured in solution do not directly exhibit any effects originating from dipolar couplings.
Residual dipolar couplings may, however, provide valuable information on the measured sample, such as distances between individual atoms, relative orientations of groups inside a molecule, information on the dynamic properties of the molecule and others.
Various attempts have therefore been made to artificially create anisotropic systems for NMR measurements, thereby re-introducing the residual dipolar couplings.
Partial alignment of molecules to observe residual dipolar couplings for structure refinement and structure determination has become a standard method in biomolecular NMR spectroscopy (Bax, 2003). The partial alignment is usually induced by anisotropic media like phospholipid bicelles (Sanders et al., 1994) or Pf1 filamentous phage (Hansen et al., 1998) which orient in the strong magnetic $B_0$ field. Recently, additional methods for alignment have been reported in which mechanical stress is put on acrylamide polymer (Tycko et al., 2000; Ishii et al., 2001; Sass et al., 2000) or acrylate/acrylamid copolymer gels (Meier et al., 2002). The alignment media thus far were designed for the use of aqueous solutions and mainly applied to biological macromolecules like proteins, nucleic acids and sugars.
For non-aqueous solutions as used mainly in routine NMR the application of poly-γ-benzyl-L-glutamate (PBLG) in $CDCl_3$ has been reported so far. The group of Curtieu has shown in a series of papers that orientation of molecules in PBLG can be used to determine optical purities via deuterium NMR (Meddour et al., 1994; Lesot et al., 1998; Sarfati et al., 2000; Canlet et al., 2000) and the groups of S. Berger and C. Griesinger exhibited examples that residual dipolar couplings inherited from PBLG-aligned small molecules can be used effectively to obtain stereochemical information (Thiele et al., 2003; Verdier et al, in press). Alignment was also reported for polyisoprene dissolved in a number of solvents (Deloche and Samulski, 1981), however, the approach had the goal to lead to specific information about the polymer and appears to be unsuited for high resolution measurements.
The approaches described above are not satisfactory for practical use for a variety of reasons. These are outlined below:
The minimum alignment possible with PBLG poses already a ∼200 Hz quadrupolar splitting on $CDCl_3$ which is too strong for the application of most heteronuclear NMR-experiments (Thiele et al., 2003; Verdier et al, in press). An alignment medium with scalable properties especially to lower alignments is therefore highly desirable.
In general, residual dipolar couplings do not lead to unambiguous structural constraints. In aqueous solution the ambiguities can be overcome by measuring different sets of residual dipolar couplings in media with differing alignment properties (Bax, 2003). For non-aqueous solvents only PBLG has been applied so far and additional media producing different alignment tensors are urgently needed.
The medium should be easy to use and well reproducible: Methods involving liquid crystalline media are generally difficult to handle and afford good technical skills since the phases are not easily reproduced. Acrylamide based polymer gels are an alternative for aqueous solutions, but even there friction with the glass walls of the NMR tube makes the use of special technical equipment necessary (Chou et al., 2001; Meier et al., 2001).
The use of polyisoprene with solvents like benzene has been shown to give quadrupolar splittings in deuterium spectra (Deloche and Samulski, 1981), but the proposed cuboid-like shape of the polymer block results in very broad deuterium linewidths of 35 Hz which makes the resulting samples useless for high resolution NMR spectroscopy. In addition, no scalability of the alignment nor the ability to measure residual dipolar couplings have been shown in this case.
It is therefore an object of the present invention to provide easy to handle alignment media permitting the measurement of residual dipolar couplings.
It is a further object of the present invention to provide alignment media having differing alignment tensors.
Another object of the present inventon is the provision of alignment media for which the amount of alignment can be scaled over a range useful for high resolution NMR.

## Summary of the Invention

In the search for solutions to the above-mentioned problems, it was discovered that cylindrical sticks of cross-linked polymers of the right diameter which are able to swell in organic solvents yield non-isotropic polymer orientation with sharp lines in NMR spectra that allow the measurement of NMR parameters like residual dipolar couplings, chemical shift changes due to CSA or quadrupolar splittings. The procedure for this is reproducible, very simple to apply, shows a scalable alignment over the range useful for NMR applications. In addition, alignment tensors differ significantly from known media.

(1) Specifically, the present invention provides a cylindrical stick for NMR measurements as defined in the appended claim 1. Preferred embodiments of the cylindrical stick according to the present invention are defined in the dependent claims 2 to 5.

(2) The present invention also provides a method of carrying out NMR measurements, involving the use of the cylindrical stick of item (1). The process of this embodiment of the present invention is specified in appended claim 7, and preferred variants of the process are indicated in dependent claims 8 and 9.

(3) Further embodiments of the present invention relate to a ready-to-use NMR tube and to a set of cylindrical sticks for NMR measurements. These are characterized in the appended claims 10 and 11.

## Description of the Figures

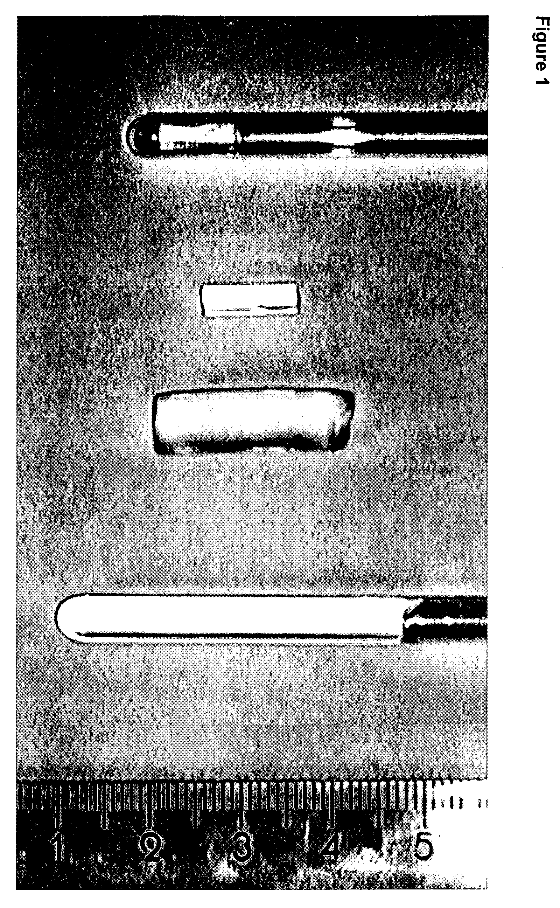

Figure 1: Photo of a cross linked polystyrene polymer stick according to the present invention. From left to right: Cylindrical polymer stick in standard NMR-tube before addition of the solvent, the cylindrical polymer stick directly after polymerization, the polymer stick swollen in $CDCl_3$, the ready to use polymer stick swollen in the standard NMR-tube using $CDCl_3$.

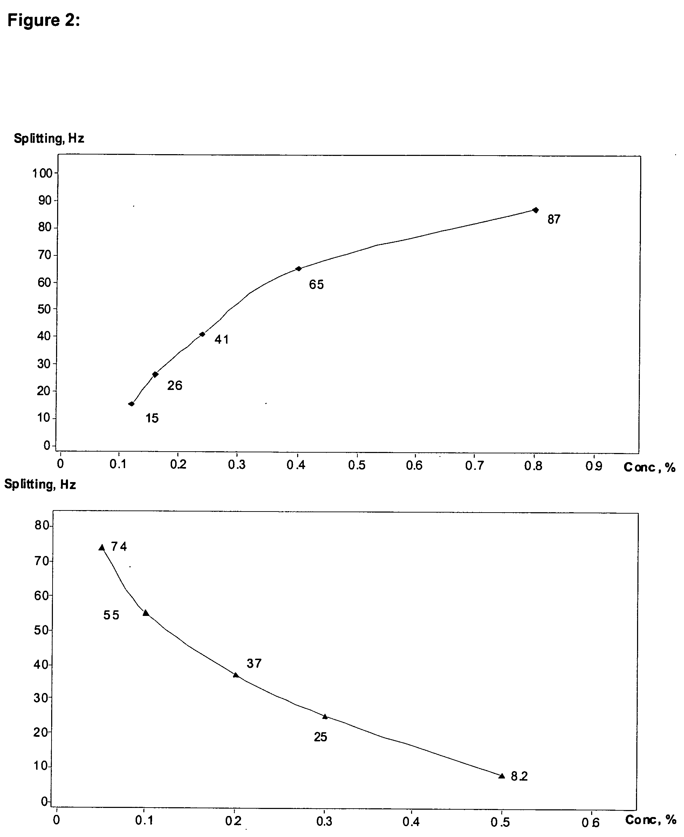

**Figure 2:** Splittings of the solvent ($CDCl_3$) deuterium NMR signal for the polymer stick (PS) of 3 mm diameter swollen in standard NMR tube depending on: concentration of divinylbenzene in the polymerized solution at a fixed concentration of benzoyl peroxyde of 0.25 % (top); concentration of benzoyl peroxyde in the polymerized solution at a fixed concentration of divinylbenzene of 0.16 % (bottom).

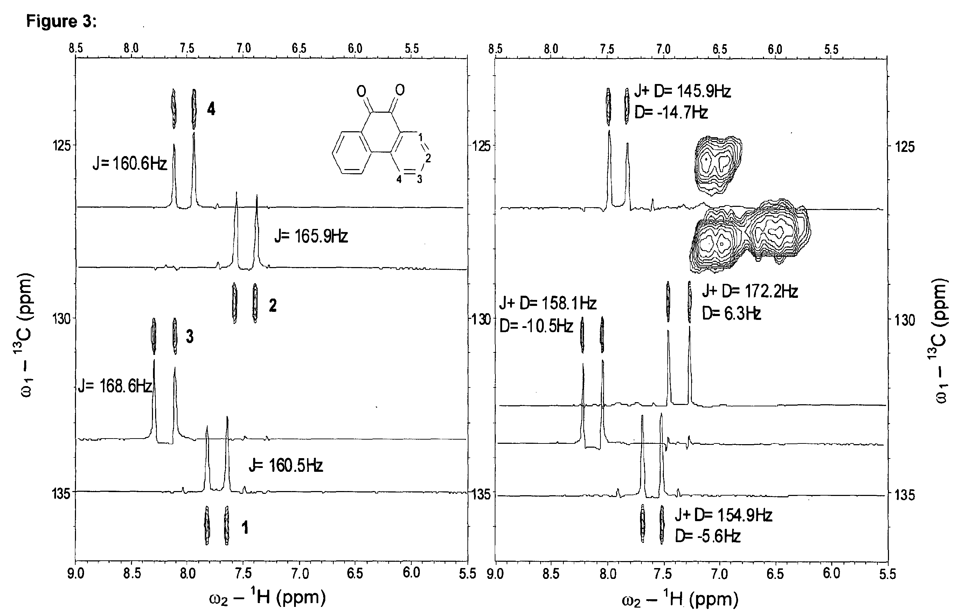

**Figure 3:** $^{13}$C-$^1$H correlation spectra (HSQC) of 9,10-phenanthrenequinone in $CDCl_3$ solution without alignment (left) and in the stretched PS gel (right). Resonance assignments are shown on the spectra as well as 1D slices at $^{13}$C frequencies of cross-peaks. Values for scalar coupling constants (J) for the unaligned sample and composite scalar and residual dipolar couplings (J+D) in the aligned sample are shown together with evaluated values for residual dipolar couplings (D). The group of strongly broadened signals in the right spectrum originates from polystyrene.

## Detailed Description of the Invention

Definitions

Unless specified otherwise, the term "polymer" as used in the present application refers to homopolymers and copolymers.
The term "NMR suitable polymer" specifies a polymer which exhibits the desired swelling properties as defined in the following section.
"NMR solvent" specifies any non-aqueous solvent that can be used for carrying out NMR measurements. Such solvents are usually deuterated.

Cylindrical Stick for NMR Spectroscopy

The present invention is based on the following discovery: It is possible to measure residual dipolar couplings in NMR experiments if an anisotropic environment is created for the sample to be measured by means of aligning the polymer chains a cross-linked polymer stick along a preferred direction. The alignment of the polymer chains is achieved by swelling the polymer in the NMR solvent under the spatial restraints of the NMR tube. The expansion of the stick in the transversal directions x and y will be restricted to the inner diameter of the NMR tube, whereas no such restriction exists for the longitudinal z direction. Accordingly, the stick will expand to a larger degree along the z direction and this will, in turn, lead to an alignment of the polymer chains along this direction.

The cylindrical stick for NMR spectroscopy according to the present invention is therefore characterized by its ability to swell in the NMR solvent of choice.

The maximum diameter of the cylindrical stick for NMR spectroscopy should be smaller than the inner diameter of the NMR tube, so that the stick can be easily introduced into the tube.

The minimum diameter of the cylindrical stick for NMR spectroscopy is determined by its ability to swell, which is determined by factors such as the polymer type and the NMR solvent. Specifically, the minimum diameter of the stick should be selected such that the stick will be in contact with the inner wall of the NMR tube after swelling.

For standard size tubes of 5 mm diameter, sticks having a diameter of about 0.1 to less than 5 mm will typically be used, with diameters of 1 to 4 mm being preferred.

Wide bore NMR tubes of 8 mm will require sticks having a larger diameter of typically 1 to 8 mm, preferably 3 to 6.5 mm.

The length of the cylindrical stick for NMR spectroscopy is not critical. A shorter stick will make it possible to use less solvent and therefore also a smaller sample amount is required. On the other hand, the length of the NMR coil should be filled by the swollen polymer gel to ensure good shimming properties of the sample.

Typical lengths of the stick before swelling will be from 1 to 50 mm, depending again on the swelling characteristics of the stick. Preferred lengths will be in the range of 5 to 20 mm.

The shape of the stick is generally cylindrical with a circular or elliptical cross-section. This shape permits to avoid that inhomogenous regions will be formed within the stick upon expansion.

It is also conceivable and within the scope of the present invention to use sticks that are formed from a multitude of thin filaments, or which are formed by rolling or wrapping a sheet of the cross-linked polymer, provided that the resulting stick exhibits the desired shape and swelling characteristics. The stick may also be formed from a granulate of the cross-linked polymer.

It is even conceivable to form sticks from different polymers having different swelling characteristics, such that the resulting swollen stick will have regions of different degrees of alignment.

Polymers

Generally, the cylindrical stick for NMR spectroscopy should consist of a cross-linked polymer, which exhibits suitable swelling characteristics. This implies that the molecular chains of the polymer are sufficiently aligned when the cylindrical stick according to the present invention is swollen in an NMR tube in the solvent to be used for the NMR measurement. As a general rule, it may be expected that this requirement will be satisfied if the swelling of the cylindrical stick at room temperature without volume constraints (such as the walls of an NMR tube) leads to an increase of the volume of the stick of 6% or more. Preferred are swelling properties that allow an increase of the volume of the stick of 50% or more.

Suitable polymers are cross-linked derivatives of the uncross-linked polymers disclosed in the Table 'Solvents and Non-Solvents for Polymers' of 'Polymer Handbook' (Immergut, E.H. and Brandrup, J., 1989). Explicitly excluded are polymers of the families of polyacrylamide and polyacrylate as these are too polar for use in non-aqueous solvents. Preferred polymers are selected from the group of polymers consisting of polydienes, polyacetylenes, polyalkenes, polyacrylic acids, polymethacrylates, polydisubstituted esters, polymethacrylamids, vinyl-based polymers, polyesters, polystyrenes, polycarbonates, polyurethanes, poly anhydrides, polysulfonates, polysulfones, silicon containing polymers such as polysiloxanes and polysilanes, polyamides. Copolymers containing two or more of the above-mentioned structural elements may also be used according to the present invention.

The polymer is cross-linked to prevent complete dissolution of the polymer in the NMR solvent. Accordingly, the minimum degree of cross-linking is determined by the solvent's capability of dissolving the polymer. An increase in the degree of cross-linking will lead to a tighter polymer network with stronger alignment properties. At a certain degree of cross-linking the polymer will be incapable of swelling, posing an upper limit on the degree of cross-linking for its use in high resolution NMR spectroscopy.

The minimum degree of swelling is determined by the necessity of solvent and sample to diffuse into the polymer stick. The diffusion of solvent and sample is roughly proportional to the swelling and a higher degree of swelling implies a lower degree of alignment. In principle, a maximum degree of swelling for use in NMR does not exist, but in practice a very loose polymer network as the case for strongly swelling polymers will give hardly measurable residual dipolar couplings. Accordingly, the practical upper limit of the suitable degree of swelling is determined by the minimum observable residual dipolar coupling (about 0.1 Hz).

The cross-linking and bulk polymerization of the polymers is effected using standard methods. These are described, for example, in (Elias, H.G., 2001). Typically, a small amount of a divalent monomer is incorporated in the monomer mixture that is polymerised to afford the uncross-linked polymer. This polymer is subsequently cross-linked using a curing agent such as a compound capable of generating radicals upon the action of UV irradiation or heat, to afford the cross-linked polymer.

As the divalent monomer, any monomer can be used, which contains two or more functional groups that can be polymerized, and which is compatible with the remaining monomers to be polymerized.

The divalent monomer is typically used in an amount of 0.05 wt.% to 2.0 wt.% based on the total weight of the monomers.

The curing agent to be used in accordance with the present invention can be selected from compounds capable of forming radicals induced by either of UV radiation, heat, β- or γ-radiation or redox reactions with the exception of paramagnetic, ferromagnetic or antiferromagnetic compounds.

NMR-Solvent

In principle, it is possible to use the cylindrical stick for NMR measurement according to the present invention with any non-aqueous solvent that is suitable for NMR spectroscopy in general. Preferred solvents are deuterated diethyl-ether, toluene, dichloromethane, chloroforme, tetrahydrofuran, 1,4-dioxane, benzene, ethyl acetate, N,N-dimethylformamide, acetone, dimethyl sulfoxide, acetonitrile, methanol.

Use of the Cylindrical Sticks for NMR Measurement

A further criterion to be met is the degree of alignment of the swollen polymer. This parameter will depend on various factors such as the type of polymer, its degree of cross-linking (see Fig. 2), the procedure of polymerization, the solvent, the temperature, the relative ratio of the diameter of the stick versus the inner diameter of the NMR tube, etc.

Specifically, it may be expected that the degree of alignment will be high if the cylindrical stick for NMR spectroscopy expands to a large degree during swelling, and if the expansion along the z direction is much larger than along the x and y directions.

The degree of expansion upon swelling is primarily determined by the selection of a suitable combination of a polymer and an NMR solvent. Herein, the NMR solvent is generally determined by the chemical structure and properties of the sample to be measured, so that a suitable polymer will then be selected on the basis of the solubility information given in e.g. the Table 'Solvents and Non-Solvents for Polymers' of the 'Polymer Handbook' (Immergut, E. H. and Brandrup, J., 1989) for the given NMR solvent. As a general rule, the NMR solvent and the polymer should be chosen such that the volume of the dried polymer stick increases at least by a factor of 1.06 upon swelling.

Another criterion for determining the appropriate combination of NMR solvent and polymer is the resulting residual dipolar splitting of the signals of interest. Using multidimensional high resolution NMR, it will be possible to detect couplings as small as 0.1 Hz. Accordingly, the conditions for alignment should be chosen such that the resulting residual dipolar splitting of the signals of interest is at least 0.1 Hz.

The size of the cylindrical stick for NMR spectroscopy should generally be chosen such that its diameter is slightly smaller (e.g. 50 to 95%, preferably 60 to 80%) than the inner diameter of the NMR tube. A critical requirement is that the diameter of the stick will swell to such a degree that the diameter of the swollen stick outside the NMR tube is larger than the inner diameter of the NMR tube.

Preparation of the ready to use NMR tube

The stick is brought into contact with the NMR solvent inside the NMR tube in order to swell the stick. There are generally two alternative strategies at this stage of the sample preparation: The sample to be measured can either be added to the stick at this stage, together with the NMR solvent, or it can be added at a later stage, when a sufficient degree of swelling is accomplished.

There should always be solvent left above the polymer gel since contact with air might induce strong friction of the dried top with the glass walls and might lead to a broken gel and no apparent alignment.

The NMR tube containing the stick, the NMR solvent and optionally the sample is then left to stand for a period of time which is sufficient to effect the desired degree of swelling and alignment. The state of equilibrium is typically reached after about 5 days, but it will also be possible to use the swollen stick before it has reached equilibrium (provided that the degree of alignment is sufficient).

If the sample has not been added together with the NMR solvent, it will be added at this stage. A further period of waiting time will then be necessary to ensure that the sample will diffuse uniformly within the swollen stick. This usually takes several hours to several days, depending on the size and the functional groups of the sample. Uniform diffusion can be verified by measuring a test NMR spectrum repeatedly until the characteristic features like splittings due to scalar and residual dipolar couplings of the spectrum do not change any longer.

NMR Measurement

The NMR sample is then ready for use and it can be introduced in the NMR spectrometer and data acquisition can be carried out as in standard NMR measurements. No specific limitations are imposed on the measurement due to the presence of the stick according to the present invention.

The potential NMR-applications are manifold: Besides the measurement of heteronuclear dipolar coupling constants, also homonuclear couplings can be used as direct structural information. In addition, residual dipolar couplings allow new ways of transferring magnetization within a molecule or between molecules. Information out of chemical shift changes due to CSA can be used for structure determination.

Any standard NMR experiment available for determining scalar coupling can be used for the determination of the residual dipolar couplings. These couplings are added to the scalar couplings in the resulting spectra.

Particularly suitable for determining residual dipolar couplings are a number of NMR-experiments designed for specific coupling measurements (e.g.: Bax, A., *et al.,* 1994 Bolon, P. J., and Prestegard, J. H. 1998; Carlomagno, T., *et al.*, 2002; Cutting, B., *et al.*, 2002; Ding, K. Y., and Gronenborn, A. M. 2002; Evenas, J., *et al.,* 2001; Fischer, M. W. F., *et al.,* 1999; Gotfredsen, C. H., *et al.,* 2000 ; Grzesiek, S., *et al.*, 1993 ; Heikkinen, S., *et al.*, 2001; Kontaxis, G., and Bax, A. 2001 ; Kontaxis, G., *et al.*, 2000 ; Lerche, M. H., *et al.*, 1999 ; Luy, B., *et al.*, 2001 ; Luy, B., and Marino, J. P., 2001; Luy, B., and Marino, J. P. 2003 ; Luy, B., *et al.*, 2002 ; Meissner, A., *et al.*, 1997; Meissner, A., *et al.*, 1997 ; Meissner, A., *et al.*, 1998 ; Meissner, A., *et al.*, 1998; Meissner, A., and Sorensen, O. W. 1997 ; Meissner, A., and Sorensen, O. W. 2000a ; Meissner, A., and Sorensen, O. W. 2000b ; Meissner, A., and Sorensen, O. W. 2000c ; Meissner, A., and Sorensen, O. W. 2001 ; Meissner, A., and Sorensen, O. W. 2002 ; Moglich, A., *et al.*, 2002 ; Neubauer, H., *et al.*, 2001 ; Ottiger, M., *et al.*, 1998 ; Ottiger, M., *et al.*, 1998 ; Permi, P., 2001 ; Permi, P., 2002 ; Permi, P., 2003 ; Peti, W., *et al.,* 2002 ; Prestegard, J. H., *et al.*, 1999 ; Schulte-Herbruggen, T., *et al.*, 2002 ; Sorensen, M. D., *et al.*, 1997 ; Sorensen, M. D., *et al.*, 1999 ; Tian, F., *et al.*, 1999 ; Tian, F., *et al.,* 1999 ; Tjandra, N., and Bax, A. 1997 ; Tolman, J. R. 2001 ; Tolman, J. R. 2002 ; Tolman, J. R., and Prestegard, J. H. 1994 ; Tolman, J. R., and Prestegard, J. H. 1996a ; Tolman, J. R., and Prestegard, J. H. 1996b ; Vuister, G. W., and Bax, A. 1993; Vuister, G. W., and Bax, A. 1994 ; Wu, Z. G., *et al.,* 2003 ; Wu, Z. R., *et al.*, 2001 ; Wu, Z. R., *et al.,* 2001 ; Yan, J. *L., et al.,* 2002; Yang, D. W., *et al.,* 1998 ; Yang, D. W., *et al.,* 1999).

The recorded data are then processed and residual dipolar couplings are extracted in the usual manner using standard software.

The residual dipolar couplings are then used to get structural information using specifically designed software such as SVD (Losonczi, J.A., *et al.,* 1999), DipoCoup (Meiler, J., *et al.,* 2000a; Meiler, J., *et al.*, 2000b; Meiler, J., *et al.,* 2000c), or PALES (Zweckstetter, M., and Bax, A., 2000; Zweckstetter, M., and Bax, A., 2001; Zweckstetter, M., and Bax, A., 2002).

The residual dipolar couplings can be used to determine the angle between the oriented sample and the external magnetic field, and also to determine distances between individual pairs of atoms within the sample. These techniques are described in (Losonczi, J.A., *et al.,* 1999, Zweckstetter, M., and Bax, A., 2000).

It will also be possible to determine the chemical shift anisotropy (CSA) of specific nuclei. This is carried out by measuring the chemical shift at different magnetic fields and filter out the CSA part which is proportional to the square of the magnetic field. The CSA can be used for structure determination (Wu, Z.R., *et al.*, 2001; Wu, Z.R., *et al.*, 2003).

Using residual dipolar couplings and CSA information from a number of different alignment media as for example polymer gels with differing polymeric units, it will be possible to obtain information on the dynamic properties of the sample (Meiler, J., *et al.,* 2001; Tolman, J.R., *et al.,* 2001; Tolman, J.R., *et al.,* 2001; Peti, W., *et al.,* 2002; Meiler, J., *et al.* 2003).

Quadrupolar couplings for nuclei with spins > ½ can be measured in aligning media. This parameter permits to determine the enantiomeric excess of a sample when using a chiral polymer.

Examples

As an example the alignment procedure is explained in detail for crosslinked polystyrene (PS) swollen in $CDCl_3$ as the non-aqueous solvent: A cylindrical PS stick of about 1.0 cm length and 3 mm in diameter is put in a standard NMR-tube with an inner diameter of about 4.5 mm and filled with 0.5 mL of $CDCl_3$ (Compare with Fig. 1). The NMR-tube is then left at room temperature for several days to allow for swelling of the PS stick and to equilibrate the polymer gel for best results. The alignment is directly visible and can be quantified by the splitting of the deuterium signal of the deuterated organic solvent. The splitting depends on the crosslinking which is controlled by the amount of divinyl benzene added in the polymerization process and the conditions under which the polymerization process takes place, as the amount of radical starter used or the temperature applied during polymerization. After the polymer gel is equilibrated, the molecule of interest can be added to the solvent on top of the gel which will then slowly diffuse into the oriented polymer. As soon as the molecule is uniformly diffused, the sample is ready for measuring RDCs.

1 cm sticks were used in the studies with $CDCl_3$ which turned out to be a good compromise.

A diameter of 3 mm turned out to be well suited to give a significant deuterium splitting in $CDCl_3$.

After addition of solvent to the PS stick the polymer starts to swell immediately and in most cases orientation of the polymer can be already achieved after few hours.

Split deuterium lines acquired on the NMR spectrometer typically show broad lines as a sign that the polymer gel has not yet equilibrated. After about five days sharp deuterium lines with the corresponding quadrupolar splitting were observed for practically all samples prepared with $CDCl_3$ as solvent. Times for swelling and equilibration might vary with the actual solvent and polymer used.

The most important issue for the alignment is the consistency of the PS stick used in the above mentioned procedure. Standard polystyrene chemistry is used. The polymerization to a cylindrical monolith can be achieved in many ways. The polystyrene chains need to be slightly cross-linked to ensure proper gel-formation. Standard methods for crosslinking PS which involves divinylbenzene (DVB) for branching the polymer chains were used. Depending on the amount of DVB added, the above procedure resulted in varying alignments as shown by the variation of the quadrupolar splitting of $CDCl_3$ in Fig. 2 (top). Benzoyl peroxide was used as a radical starter. As expected, the amount of radical starter also has an influence on the achievable alignment (Fig. 2, bottom). In the procedure shown the polymer was polymerized at 95° C, but lower polymerization temperatures are also possible.

The swollen polymer has very broad $^1$H-NMR signals in the aromatic and aliphatic region which might overlap with signals of interest. Nevertheless, with relaxation or diffusion filters these signals can be effectively reduced and in principle deuterated polymers can be used for efficient removal of these artefacts. Slight changes of chemical shifts are observed due to the effect that the polymer acts as a kind of cosolvent. If necessary, a reference spectrum can easily be obtained by using an unstretched polymer without effective alignment.

As an example we aligned phenanthren quinone in $CDCl_3$ and PS with 0.16 % DVB and 0.25 % benzoyl peroxide which resulted in a 43 Hz quadrupolar splitting of the deuterium solvent signal. In Fig. 3 HSQC-spectra of the unaligned and aligned sample are shown with one-dimensional traces from which the coupling constants were derived. The very broad cross peaks resulting from the polymer are visible in the spectra but do not interfere with the coupling constant measurement. The difference in the coupling constants from both spectra is the dipolar coupling D as given in Fig. 3. This clearly demonstrates the usefulness of the method to derive valuable NMR parameters.

In Table 1 residual dipolar couplings for menthol dissolved in $CDCl_3$ and PBLG taken from (Verdier et al., in press) with the minimum quadrupolar splitting of $CDCl_3$ in PBLG of ~200Hz are compared with residual dipolar couplings obtained using a PS gel with 0.8 % DVB and 0.25 % benzoyl peroxide swollen in $CDCl_3$ and menthol added as described above. The dipolar coupling constants are generally much smaller than the ones obtained using PBLG which makes it possible to use standard homonuclear and heteronuclear NMR experiments designed originally for measuring scalar coupling constants. The dipolar coupling constants measured in the two media are not directly proportional to each other which is a clear sign of two differing alignment tensors. Therefore the use of PS gels not only is easier to apply, but also gives complementary information to the only alignment medium established so far for measuring RDCs in non-aqueous solvents.

Table 1:

| Residual dipolar couplings measured for menthol in PBLG solution (Verdier et al., in press) and in the stretched PS gel. | | |
|---|---|---|
| Coupling partners | Dipolar couplings in PBLG (Hz) | Dipolar couplings in PS (Hz) |
| $C_1 - H_1$ | 41.5 | -4.39 |
| $C_2 - H_2^{ax}$ | 41.1 | -4.79 |
| $C_2 - H_2^{eq}$ | 9.0 | 0.13 |
| $C_3 - H_3$ | 41.4 | -3.57 |
| $C_4 - H_4$ | 43.8 | -3.26 |
| $C_5 - H_5^{ax}$ | 39.8 | -4.86 |
| $C_5 - H_5^{eq}$ | 5.3 | -0.92 |
| $C_6 - H_6^{ax}$ | 38.6 | -4.43 |
| $C_6 - H_6^{eq}$ | 4.7 | 6.23 |
| $C_8 - H_8$ | 8.5 | -7.2 |

The present invention is characterized by the following advantages: The new method is very simple to use. If prepared polymer sticks or ready to use NMR-tubes with swollen polymer gels are made commercially available the measurement of relatively new and powerful NMR-parameters like residual dipolar couplings or chemical shift changes due to CSA can easily be used by a large number of NMR spectroscopists and probably even in routine NMR services. Alignment media used today do not allow this.

Polystyrene showed already alignment properties different from PBLG, the only alignment medium characterized thus far for measuring RDCs in non-aqueous solutions. A variety of polymers swollen in non-aqueous solvents as described here will provide alignment tensors with additional orientations urgently needed especially for detailed NMR analyses including internal dynamics.

In the method of the present invention practically no linebroadening due to inhomogeneities of the polymer gel can be observed. The amount of alignment for a given polymer, well defined by the quadrupolar splitting of the deuterated solvent, can easily be scaled by changing parameters of the polymer stick like diameter, amount of cross-linking or amount of radical starter used.

**References**

Bax, A., *Protein Science 12*, 1-16 (2003).

Bax, A., Vuister, G. W., Grzesiek, S., Delaglio, F., Wang, A. C., Tschudin, R., and Zhu, G. (1994) *Nuclear Magnetic Resonance, Pt C 239*, 79-105.

Bolon, P. J., and Prestegard, J. H. (1998) *Journal of the American Chemical Society 120*, 9366-9367.

Canlet, C., Merlet, D., Lesot, P., Meddour, A., Loewenstein, A., Courtieu, J., *Tetrahedron: Asymmetry 11*, 1911-1918 (2000).

Carlomagno, T., Hennig, M., and Williamson, J. R. (2002) *Journal of Biomolecular Nmr 22*, 65-81.

Chou, J.J., Gaemers, S., Howder, B., Louis, J.M., Bax, A., J. *Biomol. NMR* 21, 377-382 (2001).

Cutting, B., Tolman, J. R., Nanchen, S., and Bodenhausen, G. (2002) *Journal of Biomolecular Nmr* 23, 195-200.

Deloche, B., Samulski, E.T., *Macromolecules 14*, 575-581 (1981).

Ding, K. Y., and Gronenborn, A. M. (2002) *Journal of Magnetic* Resonance *158*, 173-177.

Elias, H.G., Makromoleküle, Band 1-4, 6th Edition, Wiley-VCH, Weinheim (2001).

Evenas, J., Mittermaier, A., Yang, D. W., and Kay, L. E. (2001) *Journal of the American Chemical Society 123*, 2858-2864.

Fischer, M. W. F., Losonczi, J. A., Weaver, J. L., and Prestegard, J. H. (1999) *Biochemistry 38*, 9013-9022.

Gotfredsen, C. H., Meissner, A., Duus, J. O., and Sorensen, O. W. (2000) *Magnetic Resonance in Chemistry 38*, 692-695.

Grzesiek, S., Vuister, G. W., and Bax, A. (1993) *Journal of Biomolecular Nmr 3*, 487-493.

Hansen, M.R., Mueller, L., Pardi, A., *Nat. Struct. Biol. 5*, 1065-1074 (1998).

Heikkinen, S., Permi, P., and Kilpelainen, I. (2001) *Journal of Magnetic Resonance 148*, 53-60.

Immergut, E.H., and Brandrup, J., Eds. of *Polymer Handbook,* 3rd Edition, Wiley & Sons, New York (1989).

Ishii, Y., Markus, M.A., Tycko, R., *J. Biomol. NMR 21*, 141-151 (2001).

Kontaxis, G., and Bax, A. (2001) *Journal of Biomolecular Nmr 20*, 77-82.

Kontaxis, G., Clore, G. M., and Bax, A. (2000) *Journal of Magnetic Resonance 143*, 184-196.

Lerche, M. H., Meissner, A., Poulsen, F. M., and Sorensen, O. W. (1999) *Journal of Magnetic Resonance 140*, 259-263.

Lesot, P., Merlet, D., Loewenstein, A., Courtieu, J., *Tetrahedron: Asymmetry 9*, 1871-1881 (1998).

Losonczi, J. A., Andrec, M., Fischer, M. W. F., and Prestegard, J. H. (1999) *Journal of Magnetic Resonance 138*, 334-342.

Luy, B., Barchi, J. J., and Marino, J. P. (2001) *Journal of Magnetic Resonance 152*, 179-184.

Luy, B., and Marino, J. P. (2001) *Journal of Biomolecular Nmr 20*, 39-47.

Luy, B., and Marino, J. P. (2003) *Journal of Magnetic Resonance 163*, 92-98.

Luy, B., Richter, U., DeJong, E. S., Sorensen, O. W., and Marino, J. P. (2002) *Journal of Biomolecular Nmr 24,* 133-142.

Meddour, A., Canet, I., Loewenstein, A., Pechine, J.M., Courtieu, J., *J. Am. Chem. Soc. 116*, 9652-9656 (1994).

Meier, S., Häussinger, D., Grzesiek, S., *J. Biomol. NMR 24,* 351-356 (2002).

Meiler, J., Blomberg, N., Nilges, M., and Griesinger, C. (2000a) *Journal of Biomolecular Nmr 17*, 185-185.

Meiler, J., Blomberg, N., Nilges, M., and Griesinger, C. (2000b) *Journal of Biomolecular Nmr 16*, 245-252.

Meiler, J., Peti, W., and Griesinger, C. (2000c) *Journal of Biomolecular Nmr 17*, 283-294.

Meller, J., Peti, W., and Griesinger, C. (2003) *Journal of the American Chemical Society 125,* 8072-8073.

Meiler, J., Prompers, J. J., Peti, W., Griesinger, C., and Bruschweiler, R. (2001) *Journal of the American Chemical Society* 123, 6098-6107.

Meissner, A., Duus, J. O., and Sorensen, O. W. (1997) *Journal of Magnetic Resonance 128*, 92-97.

Meissner, A., Duus, J. O., and Sorensen, O. W. (1997) *Journal of Biomolecular Nmr 10*, 89-94.

Meissner, A., Schulte-Herbruggen, T., and Sorensen, O. W. (1998) *Journal of the American Chemical Society 120,* 7989-7990.

Meissner, A., Schulte-Herbruggen, T., and Sorensen, O. W. (1998) *Journal of the American Chemical Society 120,* 3803-3804.

Meissner, A., and Sorensen, O. W. (1997) *Chemical Physics Letters 276*, 97-102.

Meissner, A., and Sorensen, O. W. (2000) *Magnetic Resonance in Chemistry 38,* 981-984.

Meissner, A., and Sorensen, O. W. (2000) *Journal of Magnetic Resonance 143*, 387-390.

Meissner, A., and Sorensen, O. W. (2000) *Journal of Magnetic Resonance 143*, 431-434.

Meissner, A., and Sorensen, O. W. (2001) *Magnetic Resonance in Chemistry 39*, 49-52.

Meissner, A., and Sorensen, O. W. (2002) *Concepts in Magnetic Resonance 14,* 141-154.

Moglich, A., Wenzler, M., Kramer, F., Glaser, S. J., and Brunner, E. (2002) *Journal of Biomolecular Nmr 23*, 211-219.

Neubauer, H., Meiler, J., Peti, W., and Griesinger, C. (2001) *Helvetica Chimica Acta 84*, 243-258.

Ottiger, M., Delaglio, F., and Bax, A. (1998) *Journal of Magnetic Resonance 131,* 373-378.

Ottiger, M., Delaglio, F., Marquardt, J. L., Tjandra, N., and Bax, A. (1998) *Journal of Magnetic Resonance 134*, 365-369.

Permi, P. (2001) *Journal of Magnetic Resonance 153*, 267-272.

Permi, P. (2002) *Journal of Biomolecular Nmr 22*, 27-35.

Permi, P. (2003) *Journal of Magnetic Resonance 163*, 114-120.

Peti, W., Meiler, J., Bruschweiler, R., and Griesinger, C. (2002) *Journal of the American Chemical Society 124,* 5822-5833.

Prestegard, J. H., Bolon, P., Fischer, M., and Losonczi, J. (1999) *Abstracts of Papers of the American Chemical Society 217*, U225-U225.

Sanders, C.R., Hare, B.J., Howard, K.P., Prestegard, J.H., *Prog. Nucle. Magn. Reson. Spectr. 26*, 421-444 (1994).

Sarfati, M., Courtieu, J., Lesot, P., *Chem. Commun.,* 1113-1114 (2000).

Sass, H.-J., Musco, G., Stahl, S.J., Wingfield, P.T., Grzesiek, S., *J. Biomol. NMR 18*, 303-309 (2000).

Schulte-Herbruggen, T., Meissner, A., Papanikos, A., Meldal, M., and Sorensen, O. W. (2002) *Journal of Magnetic Resonance 156*, 282-294.

Sorensen, M. D., Meissner, A., and Sorensen, O. W. (1997) *Journal of Biomolecular Nmr 10,* 181-186.

Sorensen, M. D., Meissner, A., and Sorensen, O. VV. (1999) *Journal of Magnetic Resonance 137*, 237-242.

Thiele, C.M., Berger, S., *Organic Letters 5,* 705-708 (2003).

Tian, F., Bolon, P. J., and Prestegard, J. H. (1999) *Journal of the American Chemical Society 121,* 7712-7713.

Tian, F., Losonczi, J. A., Fischer, M. W. F., and Prestegard, J. H. (1999) *Journal of Biomolecular Nmr 15*, 145-150.

Tjandra, N., and Bax, A. (1997) *Journal of Magnetic Resonance 124*, 512-515.

Tolman, J. R. (2001) *Current Opinion in Structural Biology 11*, 532-539.

Tolman, J. R. (2002) *Journal of the American Chemical Society 124,* 12020-12030.

Tolman, J. R., and Prestegard, J. H. (1994) *Journal of Magnetic Resonance Series A 106*, 203-208.

Tolman, J. R., and Prestegard, J. H. (1996) *Journal of Magnetic Resonance Series B 112*, 245-252.

Tolman, J. R., and Prestegard, J. H. (1996) *Journal of Magnetic Resonance Series B 112*, 269-274.

Tycko, R., Blanco, F.J., Ishii, Y., J. *Am. Chem. Soc. 122*, 9340-9341 (2000).

Verdier, L., Sakhaii, P., Zweckstetter, M., Griesinger, C., *J. Magn. Reson. 163,* article in press, available online.

Vuister, G. W., and Bax, A. (1993) *Journal of the American Chemical Society 115,* 7772-7777.

Vuister, G. W., and Bax, A. (1994) *Journal of Biomolecular Nmr 4,* 193-200.

Wu, Z. G., Delaglio, F., Tjandra, N., Zhurkin, V. B., and Bax, A. (2003) *Journal of Biomolecular Nmr 26*, 297-315.

Wu, Z. R., Tjandra, N., and Bax, A. (2001) *Journal of the American Chemical Society 123*, 3617-3618.

Wu, Z. R., Tjandra, N., and Bax, A. (2001) *Journal of Biomolecular Nmr 19*, 367-370.

Yan, J. L., Corpora, T., Pradhan, P., and Bushweller, J. H. (2002) *Journal of Biomolecular Nmr 22*, 9-20.

Yang, D. W., Tolman, J. R., Goto, N. K., and Kay, L. E. (1998) *Journal of Biomolecular Nmr 12,* 325-332.

Yang, D. W., Venters, R. A., Mueller, G. A., Choy, W. Y., and Kay, L. E. (1999) *Journal of Biomolecular Nmr 14*, 333-343.

Zweckstetter, M., and Bax, A. (2000) *Journal of the American Chemical Society 122*, 3791-3792.

Zweckstetter, M., and Bax, A. (2001) *Journal of the American Chemical Society 123*, 9490-9491.

Zweckstetter, M., and Bax, A. (2002) *Journal of Biomolecular Nmr 23*, 127-137.

**Claims**

1.  Cylindrical stick for NMR measurements, consisting of a cross-linked polymer, wherein the stick has a circular or elliptical cross-section, a diameter of 0.1 to 8 mm and a length of 5 to 50 mm, and wherein the polymer used for the stick is derived from an uncross-linked polymer which is less soluble in water than polyacrylamide.

2.  Stick according to claim 1, wherein the polymer is selected from the group of polymers that are **characterized by** an increase of the volume of the polymer by a factor of at least 1.06 if the dried polymer stick is swollen in at least one of the following solvents diethyl-ether, toluene, dichloromethane, chloroform, tetrahydrofuran, 1,4-dioxane, benzene, ethyl acetate, N,N-dimethylformamide, acetone, dimethyl sulfoxide, acetonitrile, methanol.

3.  Stick according to claim 1 or 2, wherein the stick contains a polymer that is selected from the group consisting of polydienes, polyacetylenes, polyalkenes, polyacrylic acids, polymethacrylates, polydisubstituted esters, polymethacrylamids, vinyl-based polymers, polyesters, polystyrenes, polycarbonates, polyurethanes, poly anhydrides, polysulfonates, polysulfones, silicon containing polymers, polyamides.

4.  Stick according to any one of claims 1 to 3, wherein the stick consists of an arrangement of one or more pieces of filamentous or sheet-like polymers.

5.  Stick according to any one of claims 1 to 4, wherein the level of deuteration of the cross-linked polymer is increased with respect to the natural abundance of deuterium.

6.  Use of the stick according to any one of claims 1 to 5 as an additive for carrying out NMR experiments.

7.  Process of carrying out NMR experiments, comprising the following steps:

    a. bringing one or more of the sticks according to any one of claims 1 to 5 into contact with a solvent and/or the sample to be measured inside the sample tube;

    b. leaving the tube for a period of time which is sufficiently long to permit swelling of the stick or sticks and uniform diffusion of the sample within the swollen stick;

    c. optionally adding the sample to be measured;

    d. introducing the tube into an NMR spectrometer; and

    e. carrying out data acquisition.

8. Process according to claim 7, wherein a non-aqueous solvent is used.

9. Process according to claim 7 or 8, wherein the a solvent is used, in which the crosslinked polymer exhibits an increase in its volume of at least 6% upon swelling when compared with its volume in the dried state.

10. Ready-to-use NMR-tube comprising an NMR tube which contains one or more of the sticks according to any one of claims 1 to 5.

11. Set of sticks for NMR measurements, comprising two or more sticks according to any one of claims 1 to 5, wherein the sticks of the set are distinguished from each other with respect to their degree of cross-linking and/or swelling characteristics for a certain solvent and/or at least one of the following NMR properties: alignment of a standard sample; chemical shift anisotropy; quadrupolar splitting in samples or solvents containing nuclei with spin >1/2; residual dipolar couplings in a standard sample.

Figure 1

## Figure 2:

Figure 3:

## EUROPEAN SEARCH REPORT

European Patent Office

Application Number

EP 03 01 9587

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| A | DELOCHE B ET AL: "Orientation of free polymer chains dissolved in a strained elastomer: a deuterium magnetic-resonance study" EUROPHYSICS LETTERS, vol. 1, 1986, pages 629-635, XP008027236 ISSN: 0302-072X * the whole document * | 1-3,5-11 | G01R33/46 |
| A | WO 00 02953 A (AVECIA LTD) 20 January 2000 (2000-01-20) * page 1, line 3 - page 8, line 27 * | 1-3,7, 10,11 | |
| A | MAXWELL R S ET AL: "Residual dipolar coupling ..." JOURNAL OF CHEMICAL PHYSICS, vol. 116, June 2002 (2002-06), pages 10492-10502, XP008027239 ISSN: 0021-9606 * the whole document * | 1,7,10, 11 | |

TECHNICAL FIELDS SEARCHED (Int.Cl.7)

G01R

The present search report has been drawn up for all claims

| Place of search | Date of completion of the search | Examiner |
|---|---|---|
| THE HAGUE | 12 February 2004 | Volmer, W |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 03 01 9587

This annex lists the patent family members relating to the patent documents cited in the above-mentioned European search report.
The members are as contained in the European Patent Office EDP file on
The European Patent Office is in no way liable for these particulars which are merely given for the purpose of information.

12-02-2004

| Patent document cited in search report | | Publication date | Patent family member(s) | | Publication date |
|---|---|---|---|---|---|
| WO 0002953 | A | 20-01-2000 | AU | 4791199 A | 01-02-2000 |
| | | | CA | 2336914 A1 | 20-01-2000 |
| | | | EP | 1098925 A1 | 16-05-2001 |
| | | | WO | 0002953 A1 | 20-01-2000 |
| | | | JP | 2002520436 T | 09-07-2002 |
| | | | US | 6395842 B1 | 28-05-2002 |